# EUROPEAN PATENT APPLICATION

(11) **EP 3 668 282 A1**
(43) Date of publication of application: **17.06.2020**
(21) Application number: 18211577.4
(22) Date of filing: 11.12.2018
(51) Int. Cl.: H05K 1/02, H05K 3/12, C09D 11/52, H05K 1/03

(54) **CONDUCTIVE TRACES**

(71) Applicant: Nokia Technologies Oy, 02610 Espoo (FI)
(72) Inventor: ZARRA, Salvatore, New Providence, NJ New Jersey 07974 (US)
(74) Representative: Bryers LLP

(57) **Abstract**

A method of forming a conductive trace, the method comprising depositing a conductive trace material on a portion of an elastomeric substrate, a sub-portion of the elastomeric substrate comprising a first topological configuration, heating the sub-portion of the elastomeric substrate and conductive trace material deposited on that sub-portion to a first predetermined temperature, deforming the sub-portion of the elastomeric substrate and conductive trace material to a second topological configuration, and allowing the sub-portion of the elastomeric substrate and conductive trace material deposited on that sub-portion to cool to a second predetermined temperature whilst in the second topological configuration.

## Description

### TECHNICAL FIELD

Aspects relate to conductive traces, and methods for forming the same.

### BACKGROUND

Stretchable electronics and devices can be made by using the same components as used for rigid printed circuit boards, but can use a substrate and interconnections that can be stretched, compressed, and twisted for example. As such, they are capable of use in the field of wearables, smart garments and on-body/in-body electronics, and so on, as well as other applications in industrial and home Internet-of-things (IoT) devices.

### SUMMARY

According to an example, there is provided a method of forming a conductive trace, the method comprising depositing a conductive trace material on a portion of an elastomeric substrate, a sub-portion of the elastomeric substrate comprising a first topological configuration, heating the sub-portion of the elastomeric substrate and conductive trace material deposited on that sub-portion to a first predetermined temperature, deforming the sub-portion of the elastomeric substrate and conductive trace material to a second topological configuration, and allowing the sub-portion of the elastomeric substrate and conductive trace material deposited on that sub-portion to cool to a second predetermined temperature whilst in the second topological configuration. The sub-portion can be deformed into the second topological configuration by applying a strain or force thereto. The method can further comprise releasing the strain applied on the sub-portion once it has cooled to the second predetermined temperature, thereby enabling the sub-portion of the substrate to revert to the first topological configuration. The first predetermined temperature can be selected from the range 30° C to 300° C; or 70° C to 150° C; or 90° C to 130° C. The sub-portion of the elastomeric substrate and conductive trace material can be actively cooled from the first predetermined temperature to the second predetermined temperature. The sub-portion of the elastomeric substrate can be deformed by stretching in one or more directions. The method can further comprise printing the conductive trace material onto the portion of an elastomeric substrate. The conductive trace material can be a thermoformable conductive ink. The conductive trace material deposited on the sub-portion can be thermoformed. Thermoforming the conductive trace can be performed by vacuum forming, pressure forming, drape forming, or stretch forming. The elastomeric substrate can be a rubber or thermoplastic elastomer.

According to an example, there is provided a thermoformed conductive trace for use in a stretchable electronics apparatus formed on a substrate, the conductive trace applied to the substrate when the substrate is in an initial configuration and thermoformed when the substrate is in a second configuration. The trace can comprise an ink composition including conductive particles and a polymer resin. The conductive particles can be metallic or carbon-based particles, and the polymer resin can be composed of one or more of a vinyl, polyurethane or polyester resin. The conductive trace can have a softening temperature that is lower than a softening temperature of the elastomeric substrate.

### BRIEF DESCRIPTION OF THE DRAWINGS

Embodiments will now be described, by way of example only, with reference to the accompanying drawings, in which:
Figure 1 is a schematic representation of an implementation of a method according to an example as applied to a substrate; and
Figure 2 is a flowchart of a method according to an example.

### DESCRIPTION

Example embodiments are described below in sufficient detail to enable those of ordinary skill in the art to embody and implement the systems and processes herein described. It is important to understand that embodiments can be provided in many alternate forms and should not be construed as limited to the examples set forth herein.

Accordingly, while embodiments can be modified in various ways and take on various alternative forms, specific embodiments thereof are shown in the drawings and described in detail below as examples. There is no intent to limit to the particular forms disclosed. On the contrary, all modifications, equivalents, and alternatives falling within the scope of the appended claims should be included. Elements of the example embodiments are consistently denoted by the same reference numerals throughout the drawings and detailed description where appropriate.

The terminology used herein to describe embodiments is not intended to limit the scope. The articles "a," "an," and "the" are singular in that they have a single referent, however the use of the singular form in the present document should not preclude the presence of more than one referent. In other words, elements referred to in the singular can number one or more, unless the context clearly indicates otherwise. It will be further understood that the terms "comprises," "comprising," "includes," and/or "including," when used herein, specify the presence of stated features, items, steps, operations, elements, and/or components, but do not preclude the presence or addition of one or more other features, items, steps, operations, elements, components, and/or groups thereof.

Unless otherwise defined, all terms (including technical and scientific terms) used herein are to be interpreted as is customary in the art. It will be further understood that terms in common usage should also be interpreted as is customary in the relevant art and not in an idealized or overly formal sense unless expressly so defined herein.

In stretchable electronics, interconnections in the form of conductive traces for example, undergo large amounts of stress as the substrate onto (or into) which they are deposited changes shape. This can lead to changes in electrical resistance of the conductive traces when the substrate is subject to large stretching and can make them susceptible to hysteresis, that is their electrical resistance does not revert to the original value after multiple consecutive stretching (and relaxation) events.

According to an example, there is provided a method of forming a conductive trace that improves the reliable performance of conductive traces. In an example, such conductive traces do not experience a change in electrical resistance upon large stretching of the substrate onto which they are deposited.

In an example, conductive traces can comprise a thermoformable conductive ink. An Ink composition can comprise: 1) conductive particles including, for example, metal particles (e.g. silver, copper) or carbon-based particles (e.g. graphite, graphene, carbon nanotubes) or a blend of the two types; 2) a polymer resin such as, but not limited to, a vinyl resin, a polyurethane resin, a polyester resin, and combinations of these.

The conductive ink can be deposited on an un-deformed (e.g. unstretched) substrate, such as an elastomeric substrate. In an example, such elastomers can include rubbers (e.g. ethylenepropylene-diene, neoprene, silicone rubbers, fluorosilicone rubbers, perfluoroelastomers) and thermoplastic elastomers (e.g. styrenics, polyurethanes, polyamides, polyolefin blends, polyolefin alloys, thermoplastic vulcanizates).

The printed traces can then be thermoformed whilst the elastomeric substrate is deformed (e.g. stretched). In an example, it is possible that only a sub-portion of the substrate upon (or within) which the conductive trace is provided is deformed. The deformation can then be removed from the substrate, e.g. by release of strain, in order to enable it to revert to its initial configuration, thereby inducing a buckled geometry for the conductive traces.

That is, according to an example, a conductive trace material can be deposited on a portion of an elastomeric substrate, a sub-portion of which is in a first topological configuration. In an example, the first topological configuration can be a relaxed or otherwise unstressed state of the substrate. The sub-portion of the elastomeric substrate and conductive trace material can then be heated to a first predetermined temperature. The first predetermined temperature can be selected as that at which the conductive trace can be thermoformed. For example, the first predetermined temperature can be selected from the range 30° C to 300° C; or 70° C to 150° C; or 90° C to 130° C.

At the first predetermined temperature, the sub-portion of the elastomeric substrate and conductive trace material can be deformed to a second topological configuration, for example by stretching. The sub-portion of the substrate and conductive trace material can then be allowed to cool to a second predetermined temperature whilst in the second topological configuration. Once the sub-portion of the elastomeric substrate and conductive trace material have cooled to a second predetermined temperature, which is lower than the first predetermined temperature, the cause of the deformation can be removed, thereby resulting in the buckled conductive traces. In an example, the removal of the cause of deformation can be carried out at a subsequent point in time. For example, the cause of the deformation could be due to packaging (e.g. a t-shirt stretched over a cardboard cut-out), and thus the removal of the cause of the deformation may not occur until a consumer, for example, removes the product in question from the packaging, at which point the substrate may relax to the first topological configuration.

Typically, thin films are transferred to a pre-stretched elastomeric substrate so that they will be buckled after the release of pre-strain. However, in examples of the present system, a thermoformable conductive ink is deposited or printed onto an un-stretched elastomeric substrate. In a second stage, the trace is thermoformed, i.e. stretched while heat is applied. Thus, the conductive trace is first permanently rendered longer during thermoforming and then compressed when the strain is released to create a buckled printed trace.

Thermoformable inks were designed to be used on a substrate which permanently changes shape upon thermoforming. Thermoforming methods can include but are not limited to vacuum forming, pressure forming, drape forming, stretch forming.
However, in a method according to an example, thermoformable inks are used on an elastomeric substrate which does not permanently change shape during the thermoforming step. When the strain is released the elastomeric substrate goes back to its original size, whereas the thermoformed trace, which was permanently elongated, cannot go back to the original size and thus will be forced into taking a wavy shape, thus creating a buckled printed trace.

In an example, a softening temperature of a substrate can be higher than a softening temperature of a printed conductive trace. Accordingly, at a temperature high enough for the printed trace to become soft and be deformed without suffering structural damage, the substrate is still behaving as an elastomer and has not softened.

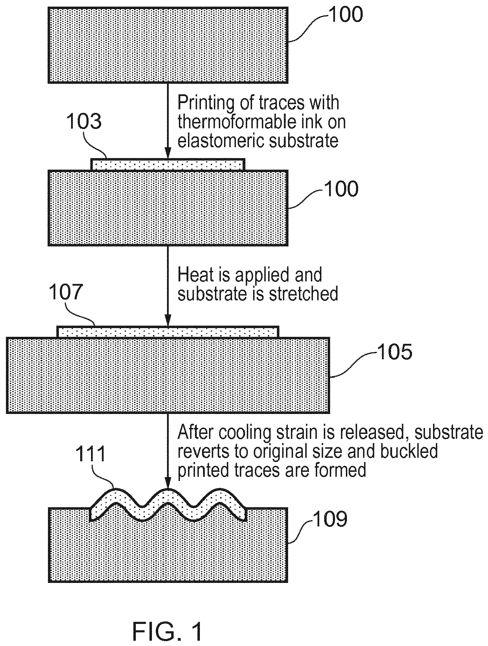

Figure 1 is a schematic representation of an implementation of a method according to an example as applied to a substrate. A substrate 100, such as an elastomeric substrate for example, is provided in a first topological configuration. In the example of figure 1, the substrate 100 is in a first state in which it is at rest, i.e. not deformed. In an example, the first topological configuration of the substrate 100 can be such that it is in an initially or prestressed configuration.

Conductive traces 103 are deposited on the substrate 100. For example, traces can be printed on a surface of the substrate 100 using a thermoformable conductive ink. Heat is applied to the substrate/trace combination to a first predetermined temperature, and the substrate is deformed into a second topological configuration 105. The heating and deformation process may be performed concurrently, or with one occurring before/after the other. As a result of the deformation of the substrate into the configuration 105, the conductive traces are also deformed 107. That is, since the conductive traces 103 are effectively adhered to the substrate 100, deformation of the substrate 100 results in a corresponding deformation of the conductive traces 103. Accordingly, in the example of figure 1, the substrate and conductive traces are stretched.

The deformed substrate 105 and conductive traces 107, having been thermoformed at the first predetermined temperature, are maintained in their deformed configuration as they are allowed to cool. Once cooled, removal of the cause of deformation will cause the substrate 105 to revert to its original size to provide substrate 109. As a result of this, the conductive traces 107 buckle to form buckled traces 111.

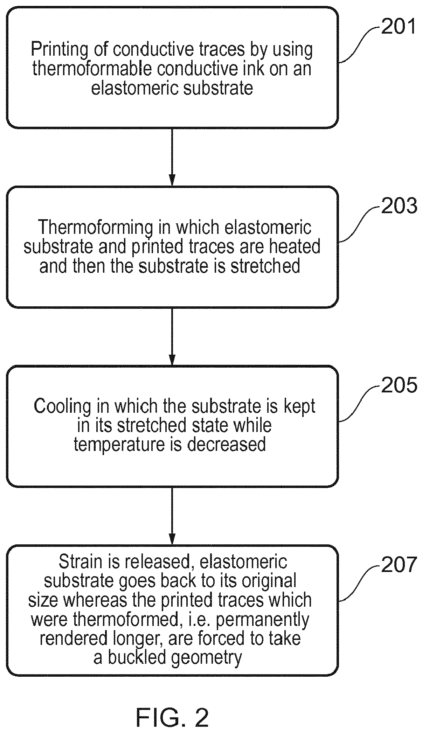

Figure 2 is a flowchart of a method according to an example. In block 201, conductive traces are printed to a substrate using a thermoformable conductive ink, thereby forming a substrate/trace structure in a first topological configuration. In block 203, a thermoforming process is executed in which the substrate/trace structure is heated and deformed. Although it may be possible to deform and then heat the structure, there is a risk of damage to the conductive traces before they have reached the temperature used for thermoforming, and so, in an example, the structure is heated to the first predetermined temperature before deformation.

In block 205, the structure, now deformed into a second topological configuration, is allowed to cool to a second predetermined temperature whilst the deformation is maintained. The reduction from the first to the second predetermined temperature can be passive (i.e. simply allowing the structure to cool naturally), or active, in which some means is employed in order to more rapidly cool the structure, such as a fan or refrigeration and so on.

In block 207, once the structure is at the second predetermined temperature, the deformation is released. The structure thus returns to the first topological configuration, and the conductive traces, which were permanently rendered longer, are forced to take on a buckled geometry that enables them to withstand repeated stretching events whilst maintaining constant or close-to-constant electrical resistance.

In an example, where the traces are deposited on large area substrates, it is possible to thermoform only some portions of the conductive traces. That is, for example, heating and deformation (i.e. thermoforming) can be applied only in some sections of a substrate so that printed traces can will rendered stretch-resistant in only those sections where it is desired.

Accordingly, with a single deposition (e.g. printing) step, conductive traces can be printed on sections of a substrate which will be subject to stretch when in use as well as sections that will not be subject to stretching during use. In a subsequent thermoforming step, traces in the first section will be rendered stretch-resistant.

The present inventions can be embodied in other specific apparatus and/or methods. The described embodiments are to be considered in all respects as illustrative and not restrictive. In particular, the scope of the invention is indicated by the appended claims rather than by the description and figures herein. All changes that come within the meaning and range of equivalency of the claims are to be embraced within their scope.

## Claims

1. A method of forming a conductive trace, the method comprising:
depositing a conductive trace material on a portion of an elastomeric substrate, a sub-portion of the elastomeric substrate comprising a first topological configuration;
heating the sub-portion of the elastomeric substrate and conductive trace material deposited on that sub-portion to a first predetermined temperature;
deforming the sub-portion of the elastomeric substrate and conductive trace material to a second topological configuration; and
allowing the sub-portion of the elastomeric substrate and conductive trace material deposited on that sub-portion to cool to a second predetermined temperature whilst in the second topological configuration.

2. The method as claimed in claim 1, wherein the sub-portion is deformed into the second topological configuration by applying a strain thereto.

3. The method as claimed in claim 2, further comprising:
releasing the strain applied on the sub-portion once it has cooled to the second predetermined temperature, thereby enabling the sub-portion of the elastomeric substrate to revert to the first topological configuration.

4. The method as claimed in any preceding claim, wherein the first predetermined temperature is selected from the range 30° C to 300° C; or 70° C to 150° C; or 90° C to 130° C.

5. The method as claimed in any preceding claim, wherein the sub-portion of the elastomeric substrate and conductive trace material are actively cooled from the first predetermined temperature to the second predetermined temperature.

6. The method as claimed in any preceding claim, wherein the sub-portion of the elastomeric substrate is deformed by stretching in one or more directions.

7. The method as claimed in any preceding claim, further comprising printing the conductive trace material onto the portion of an elastomeric substrate.

8. The method as claimed in claim 7, wherein the conductive trace material is a thermoformable conductive ink.

9. The method as claimed in any preceding claim, wherein the conductive trace material deposited on the sub-portion is thermoformed.

10. The method as claimed in claim 9, wherein thermoforming the conductive trace is performed by vacuum forming, pressure forming, drape forming, or stretch forming.

11. The method as claimed in any preceding claim, wherein the elastomeric substrate is a rubber or thermoplastic elastomer.

12. A thermoformed conductive trace for use in a stretchable electronics apparatus formed on a substrate, the conductive trace applied to the substrate when the substrate is in an initial configuration and thermoformed when the substrate is in a second configuration.

13. The thermoformed conductive trace as claimed in claim 12, wherein the trace comprises an ink composition including conductive particles and a polymer resin.

14. The thermoformed conductive trace as claimed in claim 13, wherein the conductive particles are metallic or carbon-based particles, and the polymer resin is composed of one or more of a vinyl, polyurethane or polyester resin.

15. The thermoformed conductive trace as claimed in any of claims 12 to 14, wherein the conductive trace has a softening temperature that is lower than a softening temperature of the substrate.
